# EUROPEAN PATENT APPLICATION

(11) **EP 4 808 325 A1**
(43) Date of publication of application: **16.09.2026**
(21) Application number: 26163284.8
(22) Date of filing: 09.03.2026
(51) Int. Cl.: H10K 59/131, H10K 59/88

(54) **DISPLAY DEVICE AND ELECTRONIC DEVICE**

(30) Priority: 13.03.2025 KR 20250032473
(71) Applicant: Samsung Display Co., Ltd., Yongin-si, Gyeonggi-do 17113 (KR)
(72) Inventor: Kim, Won Tae, Yongin-si, Gyeonggi-do (KR); Kim, Kang Min, Yongin-si, Gyeonggi-do (KR)
(74) Representative: Gulde & Partner

(57) **Abstract**

A display device and an electronic device are provided, in which electrical connection between a driving circuit board and a control circuit board may be improved. The display device includes a display panel, a first circuit board connected to the display panel, and a second circuit board connected to the first circuit board. The first circuit board includes a board connection terminal and a first alignment pattern extended from the board connection terminal. The second circuit board includes a board pad connected to the board connection terminal, a first counter-alignment pattern that overlaps the first alignment pattern, and a first dummy pattern arranged adjacent to the first counter-alignment pattern and which overlaps the first circuit board.

## Description

### BACKGROUND

### Field

The present disclosure relates to a display device, and more particularly, to a display device and an electronic device, in which the electrical connection between a driving circuit board and a control circuit board may be improved.

### Description of the Related Art

An organic light emitting diode display device has self-light emitting characteristics, and the thickness and weight of an organic light emitting diode display device may be reduced because it may be implemented without a separate light source, unlike a liquid crystal display device. In some aspects, an organic light emitting diode display device exhibits high-quality characteristics such as low power consumption, high luminance and high response speed, and is thus attracting attention as a next-generation display device for TVs, monitors, and portable electronic devices.

### SUMMARY

An object of the present disclosure is to provide a display device and an electronic device, in which the electrical connection between a driving circuit board and a control circuit board may be improved.

The objects of the present disclosure are not limited to those mentioned above and additional objects of the present disclosure, which are not mentioned herein, will be clearly understood by those skilled in the art from the following description of the present disclosure.

A display device according to an embodiment of the present disclosure to achieve the above object includes a display panel, a first circuit board connected to the display panel, and a second circuit board connected to the first circuit board, wherein the first circuit board includes a board connection terminal and a first alignment pattern extended from the board connection terminal, and the second circuit board includes a board pad connected to the board connection terminal, a first counter-alignment pattern that overlaps the first alignment pattern, and a first dummy pattern arranged adjacent to the first counter-alignment pattern and which overlaps the first circuit board.

A display device according to an embodiment of the present disclosure to achieve the above object includes a display panel, a first circuit board connected to the display panel, and a second circuit board connected to the first circuit board, wherein the first circuit board includes a board connection terminal, and the second circuit board includes a board pad connected to the board connection terminal, and a dummy pattern arranged adjacent to the board pad and which overlaps an edge of the first circuit board.

An electronic device according to an embodiment of the present disclosure to achieve the above object includes a display device providing a display screen, wherein the display device includes a display panel, a first circuit board connected to the display panel, and a second circuit board connected to the first circuit board, wherein the first circuit board includes a board connection terminal and a first alignment pattern extended from the board connection terminal, and the second circuit board includes a board pad connected to the board connection terminal, a first counter-alignment pattern that overlaps the first alignment pattern, and a first dummy pattern arranged adjacent to the first counter-alignment pattern and which overlaps the first circuit board.

According to the display device and electronic device of the present disclosure, electrical connection between the driving circuit board and the control circuit board may be improved.

For example, the dummy pattern may be arranged between an edge of the driving circuit board and the control circuit board, such that a step difference (e.g., a height difference) between a center portion of the driving circuit board and respective edges of the driving circuit board may be minimized. Therefore, during an attachment process between the driving circuit board and the control circuit board, a difference between contact resistance between a board connection terminal and a board pad at the center of the driving circuit board and contact resistance between the board connection terminal and the board pad at an area adjacent to respective edges of the driving circuit board may be minimized. As a result, electrical connection between the driving circuit board and the control circuit board may be improved.

The effects according to the embodiments of the present disclosure are not limited to those mentioned above and more various effects are included in the following description of the present disclosure.

The effects of the present disclosure are not limited to the above-described effects and other effects which are not described herein will become apparent to those skilled in the art from the following description.

### BRIEF DESCRIPTION OF THE DRAWINGS

The above and other aspects and features of the present disclosure will become more apparent by describing in detail example embodiments thereof with reference to the attached drawings, in which:
FIG. 1 is a plan view illustrating a display device according to an embodiment;
FIG. 2 is an enlarged view illustrating an area A of FIG. 1;
FIG. 3 is a view illustrating that a first circuit board is removed from FIG. 2;
FIG. 4 is a view selectively illustrating a first circuit board and a first driving circuit of FIG. 2;
FIG. 5 is an enlarged view illustrating an area B1 of FIG. 2;
FIG. 6 is a cross-sectional view taken along line I - I ' of FIG. 5;
FIG. 7 is a cross-sectional view taken along line II - II' of FIG. 5;
FIG. 8 is an enlarged view illustrating an area B2 of FIG. 2;
FIG. 9 is a cross-sectional view taken along line II-III' of FIG. 8;
FIG. 10 is an enlarged view illustrating a portion of a display device according to an embodiment;
FIG. 11 is an enlarged view illustrating a portion of a display device according to an embodiment;
FIG. 12 is a cross-sectional view taken along line IV-IV' of FIG. 11;
FIG. 13 is an enlarged view illustrating a portion of a display device according to an embodiment;
FIG. 14 is an enlarged view illustrating a portion of a display device according to an embodiment;
FIG. 15 is a plan view illustrating a display device according to an embodiment;
FIG. 16 is a block diagram illustrating an electronic device according to an embodiment; and
FIGS. 17, 18 and 19 illustrates schematic diagrams of electronic devices according to various embodiments.

### DETAILED DESCRIPTION

Embodiments supported by the present disclosure will now be described more fully hereinafter with reference to the accompanying drawings, in which example embodiments of the present disclosure are illustrated. Aspects supported by the present disclosure may, however, be embodied in different forms and should not be construed as limited to the embodiments set forth herein. Rather, the example embodiments are provided such that this disclosure will be thorough and complete, and will fully convey the scope of example aspects of the present disclosure to those skilled in the art.

It will also be understood that when a layer is referred to as being "on" another layer or substrate, it can be directly on the other layer or substrate, or intervening layers may also be present. The same reference numbers indicate the same components throughout the specification. In the attached figures, the thickness of layers and regions is exaggerated for clarity.

Although the terms "first", "second", and the like may be used herein to describe various elements, these elements, should not be limited by these terms. These terms may be used to distinguish one element from another element. Thus, a first element discussed below may be termed a second element without departing from teachings of one or more embodiments. The description of an element as a "first" element may not necessarily include or imply the presence of a second element or other elements. The terms "first", "second", and the like may also be used herein to differentiate different categories or sets of elements. For conciseness, the terms "first", "second", and the like may represent "first-category (or first-set)", "second-category (or second-set)", and the like, respectively.

The term "substantially," as used herein, means approximately or actually. The term "substantially equal" means approximately or actually equal. The term "substantially the same" means approximately or actually the same. The term "substantially perpendicular" means approximately or actually perpendicular. The term "substantially parallel" means approximately or actually parallel.

It is to be understood that characteristics described herein with respect to relative terms such as, for example, "high," "low," and the like may refer to the characteristics satisfying (e.g., being greater than, less than, or the like) a threshold associated with the characteristics or may refer to a relative level of the characteristics.

Features of various embodiments of the present disclosure may be combined partially or totally. As will be clearly appreciated by those skilled in the art, technically various interactions and operations are possible. Various embodiments can be practiced individually or in combination.

Hereinafter, specific example embodiments will be described with reference to the accompanying drawings.

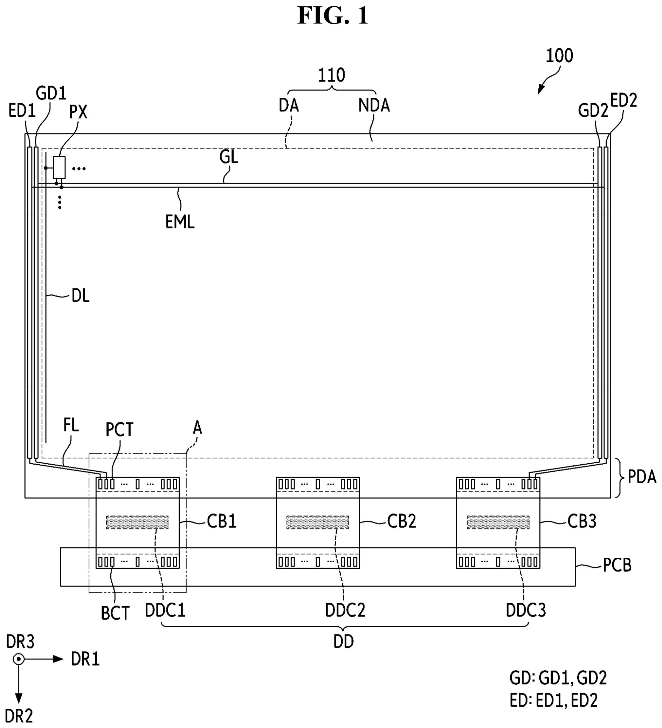

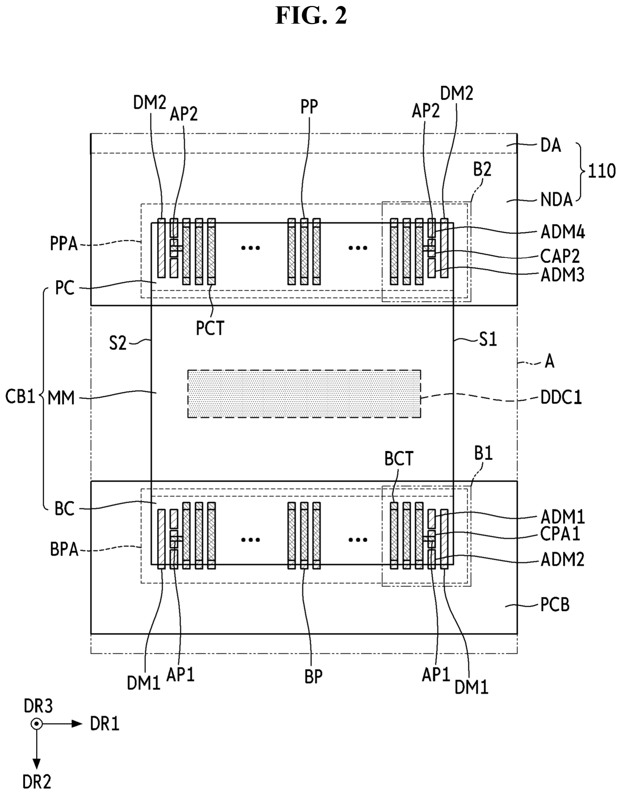

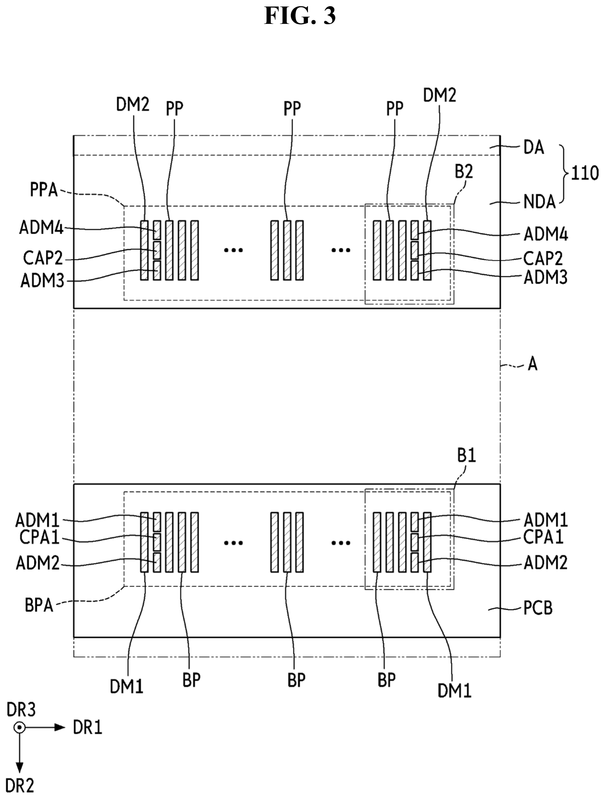

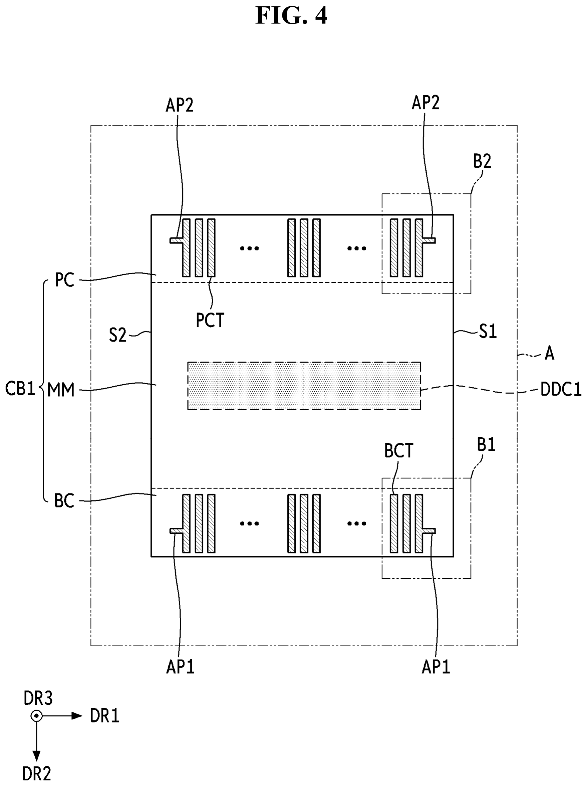

FIG. 1 is a plan view illustrating a display device 100 according to an embodiment. FIG. 2 is an enlarged view illustrating an area A of FIG. 1. FIG. 3 is a view illustrating that a first circuit board is removed from FIG. 2. FIG. 4 is a view selectively illustrating a first circuit board and a first driving circuit of FIG. 2.

Referring to FIGS. 1 and 2, the display device 100 is a device that displays a moving image or a still image, and may be used as a display screen of various products such as a television, a laptop computer, a monitor, an advertising board and a device for Internet of things (IoT) as well as portable electronic devices such as a mobile phone, a smart phone, a tablet personal computer (PC), a smart watch, a watch phone, a mobile communication terminal, an electronic diary, an electronic book, a portable multimedia player (PMP), a navigator and an ultra-mobile PC (UMPC). These are presented as examples, and the display device 100 may be used in other electronic devices.

The display device 100 may be a light emitting display device such as an organic light emitting display device including an organic light emitting diode, a quantum dot light emitting display device including a quantum dot light emitting layer, an inorganic light emitting display device including an inorganic semiconductor or a micro (or nano) light emitting display device including a micro (or nano) light emitting diode (micro LED or nano LED), but is not limited thereto. For example, the display device 100 may be another type of display device in addition to the light emitting display device. Hereinafter, the embodiments in which the display device 100 is a light emitting display device (e.g., an organic light emitting display device) will be disclosed.

The display device 100 may include a display panel 110, a gate driver GD, a light emitting driver ED, and a data driver DD, wherein the gate driver GD, the light emitting driver ED and the data driver DD supply driving signals to pixels PX of the display panel 110. The pixel PX may be arranged in a display area of the display panel 110, the gate driver GD and the light emitting driver ED may be arranged in a non-display area NDA of the display panel 110, and the data driver DD may be connected to the non-display area NDA of the display panel 110 through first circuit boards (hereinafter, referred to as driving circuit boards CB1, CB2 and CB3).

The display device 100 may further include a power supply module and a timing controller. The power supply module may supply power voltages to the pixels PX, the gate driver GD, the light emitting driver ED and the data driver DD. The timing controller may control operations of first and second gate drivers GD1 and GD2 of the gate driver GD, first and second light emitting drivers ED1 and ED2 of the light emitting driver ED, and the data driver DD.

The display panel 110 may be formed in a rectangular shape on a plane. Although FIGS. 1 and 2 show the display panel 110 having a horizontal length (e.g., a length in a first direction DR1) longer than a vertical length (e.g., a length in a second direction DR2), a shape of the display panel 110 is not limited thereto. For example, the display panel 110 may have a shape having a vertical length longer than a horizontal length, a square shape, or the like. The display panel 110 may include an edge of a round corner.

The display panel 110 may be provided as a rigid panel so as not to be substantially deformed, or may be provided as a flexible panel of which at least a portion may be deformed in a shape such as folding, bending, or rolling. The display panel 110 may be provided to the display device 100 in an unbent state, or may be provided to the display device 100 in a bent state in at least a portion.

The display panel 110 may include a display area DA and a non-display area NDA.

The plurality of pixels PX may be arranged in the display area DA. The plurality of pixels PX may display an image. The plurality of pixels PX may be connected to gate lines GL, light emission control lines EML, data lines DL, and power lines. Each of the gate line GL and the light emission control line EML may extend along the first direction DR1, and the data line DL may extend along the second direction DR2. The first direction DR1 is a horizontal direction, the second direction DR2 is a vertical direction, and the first direction DR1 and the second direction DR2 may vertically cross each other.

The non-display area NDA may be arranged around the display area DA. In an embodiment, the non-display area NDA may surround the display area DA.

The display area DA may have various shapes depending on the embodiments. For example, the display area DA may have a rectangular shape, a non-square polygonal shape, a circular shape, an oval shape, an atypical shape, or other shapes. In an embodiment, the display area DA may have a shape corresponding to the shape of the display panel 110.

The non-display area NDA may include a pad area PDA in which a plurality of pads (e.g., PP of FIG. 3; hereinafter, panel pads PP) are arranged, as illustrated in FIG. 2. For example, the pad area PDA may be arranged in the non-display area NDA (e.g., a lower non-display area) positioned below the display area DA. The plurality of panel pads PP may be arranged along the first direction DR1 in the pad area PDA. The pad area PDA of the display panel 110 may include a plurality of panel pad areas PPA, as illustrated in FIG. 3.

The gate driver GD and the light emitting driver ED may be arranged in the non-display area NDA. For example, the gate driver GD may include a first gate driver GD1 and a second gate driver GD2, and the light emitting driver ED may include a first light emitting driver ED1 and a second light emitting driver ED2, wherein the first gate driver GD1 and the first light emitting driver ED1 may be arranged in the non-display area NDA (e.g., a left non-display area) positioned on the left side of the display area DA, and the second gate driver GD2 and the second light emitting driver ED2 may be arranged in the non-display area NDA (e.g., a right non-display area) positioned on the right side of the display area DA.

The gate driver GD may drive gate lines GL. For example, the first gate driver GD1 and the second gate driver GD2 may supply gate signals to the gate lines GL, respectively. The gate lines GL may be connected to the first gate driver GD1 and the second gate driver GD2. For example, one side of each gate line GL may be electrically connected to the first gate driver GD1, and the other side of each gate line GL may be electrically connected to the second gate driver GD2.

The light emitting driver ED may drive the light emission control lines EML. For example, the first light emitting driver ED1 and the second light emitting driver ED2 may supply light emitting control signals to the light emission control lines EML, respectively. The light emission control lines EML may be connected to the first light emitting driver ED1 and the second light emitting driver ED2. As a detailed example, one side of each light emission control line EML may be electrically connected to the first light emitting driver ED1, and the other side of each light emission control line EML may be electrically connected to the second light emitting driver ED2.

The pad area of the second circuit board (hereinafter, referred to as the control circuit board PCB) may include a plurality of board pad areas BPA, as illustrated in FIG. 3.

The driving circuit boards CB1 to CB3 may include a first driving circuit board CB1, a second driving circuit board CB2, and a third driving circuit board CB3. In the present embodiment, three driving circuit boards CB1 to CB3 are disclosed, but the number of driving circuit boards is not limited thereto.

The driving circuit boards CB1 to CB3 may be connected to the display panel 110 and the control circuit board PCB. For example, as illustrated in FIGS. 1 and 2, the first driving circuit board CB1 may be connected to pads (hereinafter, referred to as panel pads PP) of the display panel 110 and pads (hereinafter, referred to as board pads BP) of the control circuit board PCB. Likewise, the second driving circuit board CB2 may be connected to the panel pads of the display panel 110 and the board pads of the control circuit board PCB, and the third driving circuit board CB3 may be connected to the panel pads of the display panel 110 and the board pads of the control circuit board PCB. Each of the driving circuit boards CB1 to CB3 may be a flexible printed circuit board (FPCB), a printed circuit board (PCB), or a flexible film such as a chip on film (COF), but is not limited thereto.

Intervals (e.g., intervals in the first direction DR1) between adjacent driving circuit boards may be the same as each other. For example, the interval between the first driving circuit board CB1 and the second driving circuit board CB2 and the interval between the second driving circuit board CB2 and the third driving circuit board CB3 may be the same as each other.

Each of the driving circuit boards CB1 to CB3 may include a plurality of terminals (or bumps). For example, as illustrated in FIGS. 2 and 4, the first driving circuit board CB1 may include a plurality of panel connection terminals PCT connected to the plurality of panel pads PP of the display panel 110 and a plurality of board connection terminals BCT connected to the plurality of board pads BP of the control circuit board PCB. Each of the second driving circuit board CB2 and the third driving circuit board CB3 may include the same terminals as those of the first driving circuit board CB1 described herein. For example, the second driving circuit board CB2 may include a plurality of panel connection terminals respectively connected to the plurality of panel pads of the display panel 110 and a plurality of board connection terminals respectively connected to the board pads of the control circuit board PCB, and the third driving circuit board CB3 may include a plurality of panel connection terminals respectively connected to the plurality of panel pads of the display panel 110 and a plurality of board connection terminals respectively connected to the board pads of the control circuit board.

The driving circuit boards CB1 to CB3 may be bent, respectively, and a portion thereof may be arranged on a rear surface of the display panel 110. In this case, a plurality of driving circuits DDC1, DDC2 and DDC3 and the control circuit board PCB may be arranged on the rear surface of the display panel 110.

A timing controller and a power supply circuit may be arranged on the control circuit board PCB. The control circuit board PCB may be a flexible printed circuit board (FPCB), a printed circuit board (PCB), or a flexible film such as a chip on film (COF), but is not limited thereto. For example, the control circuit board PCB may be a printed driving circuit board of a rigid material. Although one control circuit board PCB is disclosed in the present embodiment, the number of control circuit boards PCB is not limited thereto. For example, a plurality of control circuit boards connected to each other by a connector may be connected to the first to third driving circuit boards CB1, CB2 and CB3.

The data driver DD may include a plurality of driving circuits DDC1, DDC2 and DDC3 (hereinafter, referred to as data driving circuits) arranged along the first direction DR1. For example, the data driver DD may include a first data driving circuit DDC1 mounted in the first driving circuit board CB1, a second data driving circuit DDC2 mounted in the second driving circuit board CB2, and a third data driving circuit DDC3 mounted in the third driving circuit board CB3. Each of the data driving circuits DDC1 to DDC3 may include, for example, an integrated circuit.

Each of the data driving circuits DDC1 to DDC3 may be electrically connected to each panel pad PP of the display panel 110 through each of the driving circuit boards CB1 to CB3. For example, the first data driving circuit DDC1 may be electrically connected to the panel pads PP of the display panel 110 through the panel connection terminals PCT of the first driving circuit board CB1, the second data driving circuit DDC2 may be electrically connected to the panel pads of the display panel 110 through the panel connection terminals of the second driving circuit board CB2, and the third data driving circuit DDC3 may be electrically connected to the panel pads of the display panel 110 through the panel connection terminals of the third driving circuit board CB3. In this case, the first data driving circuit DDC1, the second data driving circuit DDC2 and the third data driving circuit DDC3 may be connected to different panel pads PPs, respectively.

The plurality of data lines DL may be connected to the data driver DD. For example, the plurality of data lines DL may be divisionally connected to the plurality of data driving circuits DDC1 to DDC3. As a detailed example, the plurality of data lines DL may include a plurality of first data lines connected to the first data driving circuit DDC1, a plurality of second data lines connected to the second data driving circuit DDC2, and a plurality of third data lines connected to the third data driving circuit DDC3.

The panel connection terminals PCT of the first driving circuit board CB1 may include a plurality of control terminals, a plurality of power terminals, and a plurality of data terminals. The control terminals of the first driving circuit board CB1 may be connected to the timing controller arranged on the control circuit board PCB. The power terminals of the first driving circuit board CB1 may be connected to the power supply module arranged on the control circuit board PCB. The data terminals of the first driving circuit board CB1 may be connected to the first data driving circuit DDC1. The board connection terminals BCT of the first driving circuit board CB1 may include control terminals, power terminals and data terminals, which correspond to the panel connection terminals PCT of the first driving circuit board CB1. The control terminals of the board connection terminals BCT provided in the first driving circuit board CB1 may be connected to the control terminals of the panel connection terminals PCT provided in the first driving circuit board CB1, the power terminals of the board connection terminals BCT provided in the first driving circuit board CB1 may be connected to the power terminals of the panel connection terminals PCT, and the data terminals of the board connection terminals BCT provided in the first driving circuit board CB1 may be connected to the first data driving circuit DDC1.

The panel connection terminals of the second driving circuit board CB2 may include a plurality of power terminals and a plurality of data terminals. The power terminals of the second driving circuit board CB2 may be connected to the power supply module arranged on the control circuit board PCB. The data terminals of the second driving circuit board CB2 may be connected to the second data driving circuit DDC2. The board connection terminals of the second driving circuit board CB2 may include power terminals and data terminals, which correspond to the panel connection terminals of the second driving circuit board CB2. The power terminals of the board connection terminals provided in the second driving circuit board CB2 may be connected to the power terminals of the panel connection terminals provided in the second driving circuit board CB2, and the data terminals of the board connection terminals provided in the second driving circuit board CB2 may be connected to the second data driving circuit DDC2.

The panel connection terminals of the third driving circuit board CB3 may include a plurality of control terminals, a plurality of power terminals, and a plurality of data terminals. The control terminals of the third driving circuit board CB3 may be connected to the timing controller arranged on the control circuit board PCB. The power terminals of the third driving circuit board CB3 may be connected to the power supply module arranged on the control circuit board PCB. The data terminals of the third driving circuit board CB3 may be connected to the third data driving circuit DDC3. The board connection terminals of the third driving circuit board CB3 may include control terminals, power terminals, and data terminals, which correspond to the panel connection terminals of the third driving circuit board CB3. The control terminals of the board connection terminals provided in the third driving circuit board CB3 may be connected to control terminals of the panel connection terminals provided in the third driving circuit board CB3, the power terminals of the board connection terminals provided in the third driving circuit board CB3 may be connected to the power terminals of the panel connection terminals provided in the third driving circuit board CB3, and the data terminals of the board connection terminals provided in the third driving circuit board CB3 may be connected to the third data driving circuit DDC3.

The panel connection terminals PCT of the first driving circuit board CB1 and the panel pads PP of the display panel 110 may be electrically connected to each other directly or through a connection member (e.g., an anisotropic conductive film) including conductive balls. The panel connection terminals of the second driving circuit board CB2 and the panel pads of the display panel 110 may be electrically connected to each other directly or through the connection member (e.g., the anisotropic conductive film) including conductive balls. The panel connection terminals of the third driving circuit board CB3 and the panel pads of the display panel 110 may be electrically connected to each other directly or through the connection member (e.g., the anisotropic conductive film) including conductive balls.

The board connection terminals BCT of the first driving circuit board CB1 and the board pads BP of the control circuit board PCB may be electrically connected to each other directly or through the connection member such as conductive balls. The board connection terminals of the second driving circuit board CB2 and the board pads of the control circuit board PCB may be electrically connected to each other directly or through the connection member such as conductive balls. The board connection terminals of the third driving circuit board CB3 and the board pads of the control circuit board PCB may be electrically connected to each other directly or through the connection member such as conductive balls. In this case, the board connection terminals BCT of the first driving circuit board CB1, the board connection terminals of the second driving circuit board CB2, and the board connection terminals of the third driving circuit board CB3 may be connected to different board pads BP.

The panel pads PP of the display panel 110 may include a plurality of first control pads, a plurality of first power pads, a plurality of first data pads, a plurality of second power pads, a plurality of second data pads, a plurality of second control pads, a plurality of third power pads, and a plurality of third data pads.

The first control pads of the panel pads PP may be connected to the control terminals of the panel connection terminals PCT provided in the first driving circuit board CB1, respectively. In some aspects, the first control pads may be connected to the first gate driver GD1 and the first light emitting driver ED1. The first power pads of the panel pads PP may be connected to the power terminals of the panel connection terminals PCT provided in the first driving circuit board CB1, respectively. In some aspects, the first power pads of the panel pads PP may be connected to the first gate driver GD1, the first light emitting driver ED1, and the pixels PX. The first data pads of the panel pads PP may be connected to the data terminals of the panel connection terminals PCT provided in the first driving circuit board CB1, respectively. In some aspects, the first data pads of the panel pads PP may be connected to the first data lines, respectively.

The second power pads of the panel pads PP may be connected to the power terminals of the panel connection terminals provided in the second driving circuit board CB2, respectively. In some aspects, the second power pads of the panel pads PP may be connected to the pixels PX. The second data pads of the panel pads PP may be connected to the data terminals of the panel connection terminals provided in the second driving circuit board CB2, respectively. In some aspects, the second data pads of the panel pads PP may be connected to the second data lines, respectively.

The second control pads of the panel pads PP may be connected to the control terminals of the panel connection terminals provided in the third driving circuit board CB3, respectively. In some aspects, the second control pads of the panel pads PP may be connected to the second gate driver GD2 and the second light emitting driver ED2. The third power pads of the panel pads PP may be connected to the power terminals of the panel connection terminals provided in the third driving circuit board CB3, respectively. In some aspects, the third power pads of the panel pads PP may be connected to the pixels PX. The third data pads of the panel pads PP may be connected to the data terminals of the panel connection terminals provided in the third driving circuit board CB3, respectively. In some aspects, the third data pads of the panel pads PP may be connected to the third data lines, respectively.

The first control pads and the first gate driver GD1 may be electrically connected to each other through corresponding fan-out lines FL, and other first control pads and the first light emitting driver ED1 may be electrically connected to each other through corresponding fan-out lines FL.

The second control pads and the second gate driver GD2 may be electrically connected to each other through corresponding fan-out lines FL, and other second control pads and the second light emitting driver ED2 may be electrically connected to each other through corresponding fan-out lines FL.

The first to third data pads may be electrically connected to the first to third data lines through the corresponding fan-out lines FL.

A gate timing control signal, a light emission timing control signal, a gate clock signal, a light emission clock signal, a gate start signal, a light emission start signal, a high potential voltage, and a low potential voltage may be supplied to the first gate driver GD1 and the first light emitting driver ED1 through the control terminals of the first driving circuit board CB1 and the first control pads of the display panel 110. For example, the gate timing control signal, the gate clock signal, the gate start signal, the high potential voltage, and the low potential voltage may be supplied to the first gate driver GD1, and the light emission timing control signal, the light emission start signal, the high potential voltage, and the low potential voltage may be supplied to the first light emitting driver ED1. Power signals from the power supply module may be supplied to the first gate driver GD1, the first light emitting driver ED1, and the pixels PX through the power terminals of the first driving circuit board CB1 and the first power pads of the display panel 110. The power signals may include, for example, a driving voltage, a common voltage, an initialization voltage, and a bias voltage. Data signals from the first data driving circuit DDC1 may be supplied to the first data lines, respectively, through the data terminals of the first driving circuit board CB1 and the first data pads of the display panel 110.

The power signals from the power supply module may be supplied to the pixels PX through the power terminals of the second driving circuit board CB2 and the second power pads of the display panel 110. Data signals from the second data driving circuit DDC2 may be supplied to the second data lines, respectively, through the data terminals of the second driving circuit board CB2 and the second data pads of the display panel 110.

The gate timing control signal, the light emission timing control signal, the gate clock signal, the light emission clock signal, the high potential voltage, and the low potential voltage from the timing controller may be supplied to the second gate driver GD2 and the second light emitting driver ED2 through the control terminals of the third driving circuit board CB3 and the second control pads of the display panel 110. For example, the gate timing control signal, the gate clock signal, the high potential voltage, and the low potential voltage may be supplied to the second gate driver GD2, and the light emission timing control signal, the light emission clock signal, the high potential voltage, and the low potential voltage may be supplied to the second light emitting driver ED2. The power signals from the power supply module may be supplied to the second gate driver GD2, the second light emitting driver ED2, and the pixels PX through the power terminals of the third driving circuit board CB3 and the third power pads of the display panel 110. Data signals from the third data driving circuit DDC3 may be supplied to the third data lines, respectively, through the data terminals of the third driving circuit board CB3 and the third data pads of the display panel 110. The high potential voltage may be greater than the driving voltage, and the low potential voltage may be less than the common voltage.

As illustrated in FIGS. 2 and 4, the first driving circuit board CB1 may include a mounting module MM, a panel connection module PC, and a board connection module BC.

The panel connection module PC may be arranged on the display panel 110. For example, the panel connection module PC may be arranged in the non-display area NDA (e.g., the panel pad area PPA of the non-display area NDA) of the display panel 110 and overlap the panel pads PP of the display panel 110. The panel connection module PC may include a plurality of panel connection terminals PCT. The plurality of panel connection terminals PCT of the panel connection module PC may overlap the plurality of panel pads PP of the display panel 110, respectively. The panel connection terminals PCT may be arranged along the first direction DR1. The panel connection module PC may be a portion connected to the display panel 110. For example, the panel connection terminals PCT of the panel connection module PC may be connected to the panel pads PP of the display panel 110 by pressure and heat, respectively, and the above-described pressure and heat may be applied to the panel connection module PC.

The board connection module BC may be arranged on the control circuit board PCB. For example, the board connection module BC may be arranged on the board pad area BPA of the control circuit board PCB and overlap the board pads BP of the control circuit board PCB. The board connection module BC may include a plurality of board connection terminals BCT. The plurality of board connection terminals BCT of the board connection module BC may overlap the plurality of board pads BP of the control circuit board PCB, respectively. The board connection terminals BCT may be arranged along the first direction DR1. The board connection module BC may be a portion connected to the control circuit board PCB. For example, the board connection terminals BCT of the board connection module BC may be connected to the board pads BP of the control circuit board PCB by pressure and heat, respectively, and the above-described pressure and heat may be applied to the board connection module BC.

The mounting module MM may be arranged between the panel connection module PC and the board connection module BC. The mounting module MM may include a first data driving circuit DDC1. For example, the first data driving circuit DDC1 may be arranged (or mounted) in the mounting module MM.

The first driving circuit board CB1 may further include at least one first alignment pattern AP1. For example, at least one first alignment pattern AP1 may be arranged in the board connection module BC of the first driving circuit board CB1. The first alignment pattern AP1 may be arranged at an edge of the board connection module BC. As illustrated in FIGS. 2 and 4, two first alignment patterns AP1 may be arranged in the board connection module BC. One first alignment pattern AP1 may be arranged at one edge of the board connection module BC, and the other first alignment pattern AP1 may be arranged at the other edge of the board connection module BC. In detail, one first alignment pattern AP1 may be arranged adjacent to a first side S1 of the first driving circuit board CB1 in the board connection module BC, and the other first alignment pattern AP1 may be arranged adjacent to a second side S2 of the first driving circuit board CB1 in the board connection module BC. The two first alignment patterns AP1 may face each other in the first direction DR1.

An extending direction of the first alignment pattern AP1 may intersect an extending direction of the board connection terminal BCT. For example, since the board connection terminal BCT may extend along the second direction DR2, the first alignment pattern AP1 may extend in the first direction DR1 vertically intersecting the second direction DR2.

The first alignment pattern AP1 may be formed integrally with the board connection terminal BCT arranged at the outermost portion of the first driving circuit board CB1. For example, the first alignment pattern AP1 arranged at one edge of the board connection module BC may be formed integrally with the board connection terminal BCT arranged at the outermost portion of one side of the board connection module BC, and the first alignment pattern AP1 arranged at the other edge of the board connection module BC may be formed integrally with the board connection terminal BCT arranged at the outermost portion of the other side of the board connection module BC.

In some aspects, the first driving circuit board CB1 may further include at least one second alignment pattern AP2. For example, at least one second alignment pattern AP2 may be arranged in the panel connection module PC of the first driving circuit board CB1. The second alignment pattern AP2 may be arranged at an edge of the panel connection module PC. As illustrated in FIGS. 2 and 4, two second alignment patterns AP2 may be arranged in the panel connection module PC. One second alignment pattern AP2 may be arranged at one edge of the panel connection module PC, and the other second alignment pattern AP2 may be arranged at the other edge of the panel connection module PC. In detail, one second alignment pattern AP2 may be arranged adjacent to the first side S1 of the first driving circuit board CB1 in the panel connection module PC, and the other second alignment pattern AP2 may be arranged adjacent to the second side S2 of the first driving circuit board CB1 in the panel connection module PC. The two second alignment patterns AP2 may face each other in the first direction DR1.

An extending direction of the second alignment pattern AP2 may intersect an extending direction of the pad connection terminal PCT. For example, since the pad connection terminal PCT may extend along the second direction DR2, the second alignment pattern AP2 may extend in the first direction DR1 vertically intersecting the second direction DR2.

The second alignment pattern AP2 may be formed integrally with the pad connection terminal PCT arranged at the outermost portion of the first driving circuit board CB1. For example, the second alignment pattern AP2 arranged at one edge of the panel connection module PC may be formed integrally with the pad connection terminal PCT arranged at the outermost portion of one side of the panel connection module PC, and the second alignment pattern AP2 arranged at the other edge of the panel connection module PC may be formed integrally with the pad connection terminal PCT arranged at the other outermost portion of the panel connection module PC.

The control circuit board PCB may further include a first counter-alignment pattern CAP1, a first dummy pattern DM1, a first auxiliary dummy pattern ADM1, and a second auxiliary dummy pattern ADM2, which overlap the first driving circuit board CB1. In some aspects, the control circuit board PCB may further include a second counter-alignment pattern CAP2, a second dummy pattern DM2, a third auxiliary dummy pattern ADM3, and a fourth auxiliary dummy pattern ADM4, which overlap the first driving circuit board CB1.

The first alignment pattern AP1 and the first counter-alignment pattern CAP1 may overlap each other. An alignment state in the second direction DR2 between the first driving circuit board CB1 and the control circuit board PCB may be determined based on a position of the first alignment pattern AP1 on the first counter-alignment pattern CAP1. In an example in which the first alignment pattern AP1 overlaps a center of the first counter-alignment pattern CAP1, it may be determined that the first driving circuit board CB1 and the control circuit board PCB are normally aligned along the second direction DR2.

The second alignment pattern AP2 may overlap the second counter-alignment pattern CAP2. An alignment state in the second direction DR2 between the first driving circuit board CB1 and the display panel 110 may be determined based on a position of the second alignment pattern AP2 on the second counter-alignment pattern CAP2. In an example in which the second alignment pattern AP2 overlaps the center of the second counter-alignment pattern CAP2, it may be determined that the first driving circuit board CB1 and the display panel 110 are normally aligned along the second direction DR2.

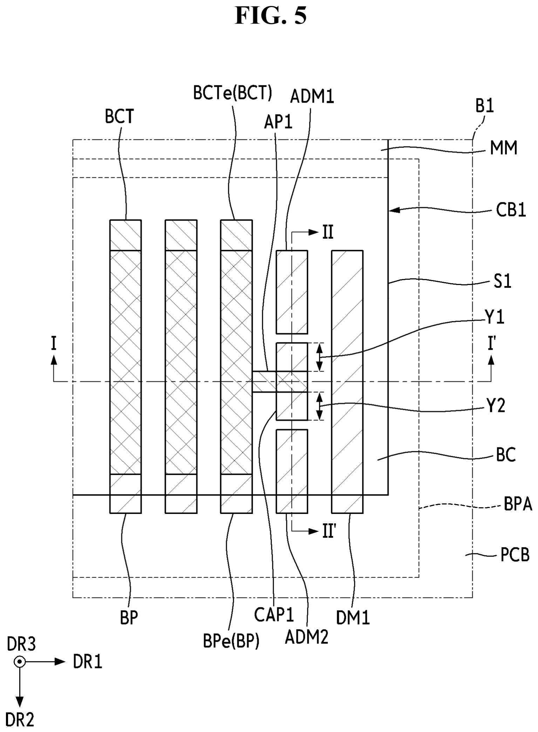

Hereinafter, the first alignment pattern AP1, the first counter-alignment pattern CAP1, the first dummy pattern DM1, the first auxiliary dummy pattern ADM1, and the second auxiliary dummy pattern ADM2, which are described herein with reference to FIGS. 5, 6 and 7, will be described in detail as follows.

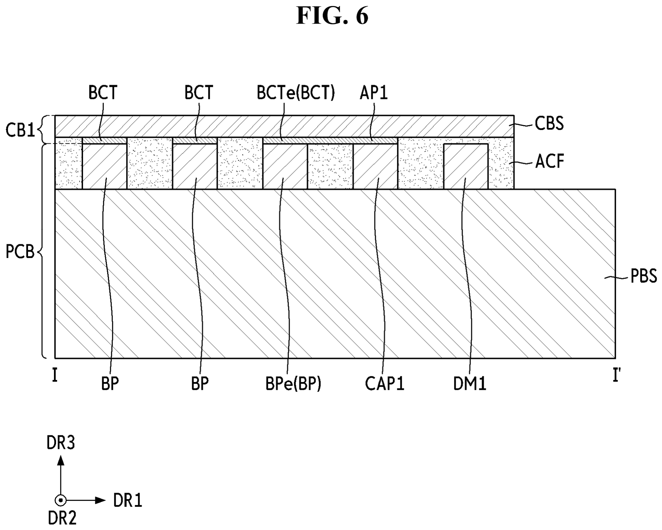

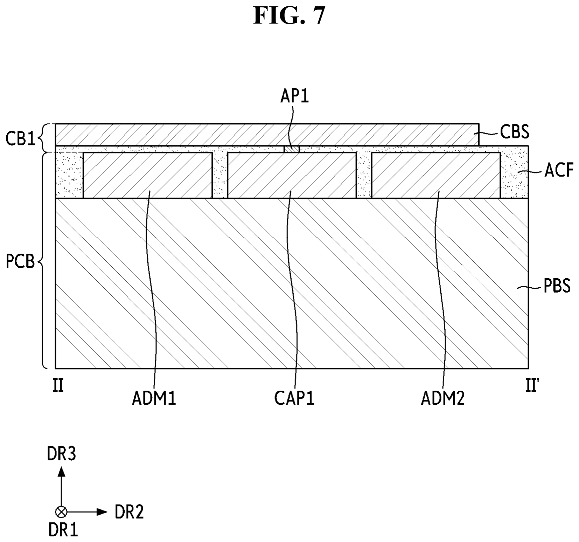

FIG. 5 is an enlarged view illustrating an area B1 of FIG. 2, FIG. 6 is a cross-sectional view taken along line I - I ' of FIG. 5, and FIG. 7 is a cross-sectional view taken along line II - II' of FIG. 5.

As illustrated in FIGS. 6 and 7, the control circuit board PCB may include a base module PBS, a plurality of board pads BP, a first counter-alignment pattern CAP1, a first dummy pattern DM1, a first auxiliary dummy pattern ADM1, and a second auxiliary dummy pattern ADM2. The first counter-alignment pattern CAP1 and the first dummy pattern DM1 may be arranged on the base module PBS (e.g., an upper surface of the base module PBS). The plurality of board pads BP, the first counter-alignment pattern CAP1, the first dummy pattern DM1, the first auxiliary dummy pattern ADM1, and the second auxiliary dummy pattern ADM2 may be formed of the same material (e.g., metal).

The first counter-alignment pattern CAP1 may be arranged adjacent to the board pad BP in the first direction DR1. For example, the pad area of the control circuit board PCB may include a plurality of board pad areas BPA to which the plurality of driving circuit boards CB1 to CB3 are connected, and thus the first counter-alignment pattern CAP1 may be arranged adjacent to an outermost board pad BP (hereinafter, referred to as an outermost board pad BPe) at one side among the plurality of board pads BP arranged in the board pad area BPA (hereinafter, the first board pad area BPA) to which the first driving circuit board CB1 is connected. In detail, the first counter-alignment pattern CAP1 may be arranged between the outermost board pad BPe and the first dummy pattern DM1 in the first direction DR1. The outermost board pad BPe may be arranged at an outermost portion of one side in the first board pad area BPA. A size (e.g., an area) of the first counter-alignment pattern CAP1 may be smaller than a size (e.g., an area) of the board pad BP. In this case, the area may be a size in the first direction DR1 and the second direction DR2.

The first dummy pattern DM1 may be arranged adjacent to the first counter-alignment pattern CAP1 in the first direction DR1. For example, the first dummy pattern DM1 may be arranged between the first counter-alignment pattern CAP1 and one edge (or the first side S1 of the first driving circuit board CB1) of the first board pad area BPA in the first direction DR1. The first dummy pattern DM1 may overlap the edge of the first driving circuit board CB1. The first dummy pattern DM1 may have the same size (e.g., area) as the board pad BP. A thickness of the first dummy pattern DM1 may be the same as a thickness of the board pad BP. The first dummy pattern DM1 and the board pad BP may have the same shape. In this case, the area may be a size in the first and second directions DR1 and DR2, and the thickness may be a size in the third direction DR3.

The first auxiliary dummy pattern ADM1 may be arranged between one side of the outermost board pad BPe and the first dummy pattern DM1 in the first direction DR1. A size (e.g., an area) of the first auxiliary dummy pattern ADM1 may be smaller than a size (e.g., an area) of the board pad BP. A size (e.g., an area) of the first auxiliary dummy pattern ADM1 may be the same as a size (e.g., an area) of the first counter-alignment pattern CAP1. The first auxiliary dummy pattern ADM1 and the first counter-alignment pattern CAP1 may have the same shape.

The second auxiliary dummy pattern ADM2 may be arranged between the other side of the outermost board pad BPe and the first dummy pattern DM1. A size of the second auxiliary dummy pattern ADM2 may be smaller than the size of the board pad BP. The second auxiliary dummy pattern ADM2 and the first auxiliary dummy pattern ADM1 may have the same size. For example, the size (e.g., area) of the first auxiliary dummy pattern ADM1, the size (e.g., area) of the second auxiliary dummy pattern ADM2, and the size (e.g., area) of the first counter-alignment pattern CAP1 may be the same as one another. The second auxiliary dummy pattern ADM2 and the first auxiliary dummy pattern ADM1 may have the same shape. For example, the first auxiliary dummy pattern ADM1, the second auxiliary dummy pattern ADM2, and the first counter-alignment pattern CAP1 may have the same shape.

The first auxiliary dummy pattern ADM1, the first counter-alignment pattern CAP1, and the second auxiliary dummy pattern ADM2 may be arranged in a line in one direction (e.g., the second direction DR2).

The first auxiliary dummy pattern ADM1, the first counter-alignment pattern CAP1, and the second auxiliary dummy pattern ADM2 may be arranged between the board pad BP (e.g., the outermost board pad BPe) and the first dummy pattern.

The first counter-alignment pattern CAP1 described herein may be arranged between the first auxiliary dummy pattern ADM1 and the second auxiliary dummy pattern ADM2 in the second direction DR2. The first counter-alignment pattern CAP1 and the first auxiliary dummy pattern ADM1 may be spaced apart from each other in the second direction DR2 so as not to be connected to each other. The first counter-alignment pattern CAP1 and the second auxiliary dummy pattern ADM2 may be spaced apart from each other in the second direction DR2 so as not to be connected to each other.

As illustrated in FIGS. 6 and 7, the first driving circuit board CB1 may include a base module CBS, a plurality of board connection terminals BCT and a first alignment pattern AP1. The plurality of board connection terminals BCT and the first alignment pattern AP1 may be arranged on the base module CBS (e.g., a lower surface of the base module CBS). The second alignment pattern AP2 and the first data driving circuit DDC1 may also be arranged on the base module CBS (e.g., the lower surface of the base module CBS). In this case, the plurality of board connection terminals BCT, the first alignment pattern AP1, and the second alignment pattern AP2 may be formed of the same material (e.g., metal). The board connection terminals BCT of the first driving circuit board CB1 and the first alignment pattern AP1 may be arranged between the base module PBS of the control circuit board PCB and the base module CBS of the first driving circuit board CB1. The base module CBS of the first driving circuit board CB1 may be formed of, for example, a material including polyimide.

As illustrated in FIGS. 5 and 6, the first alignment pattern AP1 of the first driving circuit board CB1 may be connected to the board connection terminal BCT (hereinafter, referred to as an outermost board connection terminal BCTe) arranged at an outermost portion of one side of the plurality of board connection terminals BCT of the first driving circuit board CB1. The first alignment pattern AP1 may extend from the outermost board connection terminal BCTe toward one edge (or the first side S1 of the first driving circuit board CB1) of the board connection module BC. For example, the first alignment pattern AP1 may extend from the outermost board connection terminal BCTe in the first direction DR1. The first alignment pattern AP1 and the outermost board connection terminal BCTe may be formed integrally with each other. The first alignment pattern AP1 may be formed of the same material (e.g., metal) as the material of the outermost board connection terminal BCTe.

The first alignment pattern AP1 may overlap the first counter-alignment pattern CAP1 of the control circuit board PCB. A size of the first alignment pattern AP1 in the second direction DR2 may be smaller than a size of the first counter-alignment pattern CAP1 in the second direction DR2. In an example in which a distance Y1 between the first alignment pattern AP1 and one edge of the first counter-alignment pattern CAP1 is the same as a distance Y2 between the first alignment pattern AP1 and the other edge of the first counter-alignment pattern CAP1 in a plan view as illustrated in FIG. 5, it may be determined that the first driving circuit board CB1 and the control circuit board PCB are normally aligned along the second direction DR2.

A connection member ACF (for example, an anisotropic conductive film) including conductive balls may be arranged between the control circuit board PCB and the board connection module BC of the first driving circuit board CB1. The board pads BP of the control circuit board PCB and the board connection terminals BCT of the first driving circuit board CB1 may be electrically connected to each other by the conductive balls of the connection member ACF.

The thickness of the board pad BP, the thickness of the first counter-alignment pattern CAP1, the thickness of the first dummy pattern DM1, the thickness of the first auxiliary dummy pattern ADM1, and the thickness of the second auxiliary dummy pattern ADM2 may be the same as one another. In this case, the thickness may be the size in the third direction DR3.

The thickness of the board connection terminal BCT and the thickness of the first alignment pattern AP1 may be the same as each other. In this case, the thickness of the board pad BP may be greater than the thickness of the board connection terminal BCT.

According to one embodiment, the first dummy pattern DM1 may be arranged between the edge of the base module CBS of the first driving circuit board CB1 and the base module PBS of the control circuit board PCB. Accordingly, during the process of attaching the first driving circuit board CB1 and the control circuit board PCB to each other, a step difference (e.g., a height difference) between a center portion (e.g., a center portion of the first driving circuit board CB1, which overlaps the board pads BP) of the first driving circuit board CB1 and respective edges (e.g., respective edges of the first driving circuit board CB1, which do not overlap the board pads BP) of the first driving circuit board CB1 may be minimized. For example, heat and pressure may be applied to the base module PBS of the first driving circuit board CB1 during the process of attaching the first driving circuit board CB1 to the control circuit board PCB, and in this case, respective edges of the first driving circuit board CB1, which are not supported by the board pads BP, may be more deformed than the other portions of the first driving circuit board CB1. However, according to an embodiment, since the first dummy pattern DM1 is arranged on the control circuit board PCB corresponding to respective edges of the first driving circuit board CB1, respective edges of the first driving circuit board CB1 may be supported by the first dummy pattern DM1 during the process of attaching the first driving circuit board CB1 to the control circuit board PCB. Accordingly, the step difference in the first driving circuit board CB1 may be minimized. As a result, during the process of attaching the first driving circuit board CB1 to the control circuit board PCB, contact resistance (hereinafter, referred to as first contact resistance) between the board connection terminal BCT and the board pad BP at the center portion of the first driving circuit board CB1 and contact resistance (hereinafter, referred to as second contact resistance) between the board connection terminal BCT and the board pad BP in an area adjacent to respective edges of the first driving circuit board CB1 may be maintained almost the same as each other. In other words, deviation between the first contact resistance and the second contact resistance may be minimized. Accordingly, electrical connection between the first driving circuit board CB1 and the control circuit board PCB may be improved.

In some aspects, according to an embodiment, the first auxiliary dummy pattern ADM1 and the second auxiliary dummy pattern ADM2 may be arranged on respective sides of the first counter-alignment pattern CAP1, and thus the step difference in the first driving circuit board CB1 may be further minimized by the first auxiliary dummy pattern ADM1 and the second auxiliary dummy pattern ADM2. At least one of the first auxiliary dummy pattern ADM1 or the second auxiliary dummy pattern ADM2 may be omitted.

Other driving circuit boards (e.g., the second driving circuit board CB2 and the third driving circuit board CB3) may also have the same configuration as those of the first driving circuit board CB1. For example, each of the second driving circuit board CB2 and the third driving circuit board CB3 may include a first alignment pattern AP1. In this case, the control circuit board PCB may further include a first counter-alignment pattern CAP1 that overlaps the first alignment pattern AP1 of the second driving circuit board CB2, and a first counter-alignment pattern CAP1 that overlaps the first alignment pattern AP1 of the third driving circuit board CB3. In some aspects, the control circuit board PCB may further include a first dummy pattern DM1 that overlaps the edge of the second driving circuit board CB2, and a second dummy pattern DM2 that overlaps the edge of the third driving circuit board CB3. Furthermore, the control circuit board PCB may further include first and second auxiliary dummy patterns ADM1 and ADM2, which are arranged at respective sides of the first alignment pattern AP1 of the second driving circuit board CB2 and spaced apart from the first alignment pattern AP1, and first and second auxiliary dummy patterns ADM1 and ADM2, which are arranged at respective sides of the first alignment pattern AP1 of the third driving circuit board CB3 and spaced apart from the first alignment pattern AP1.

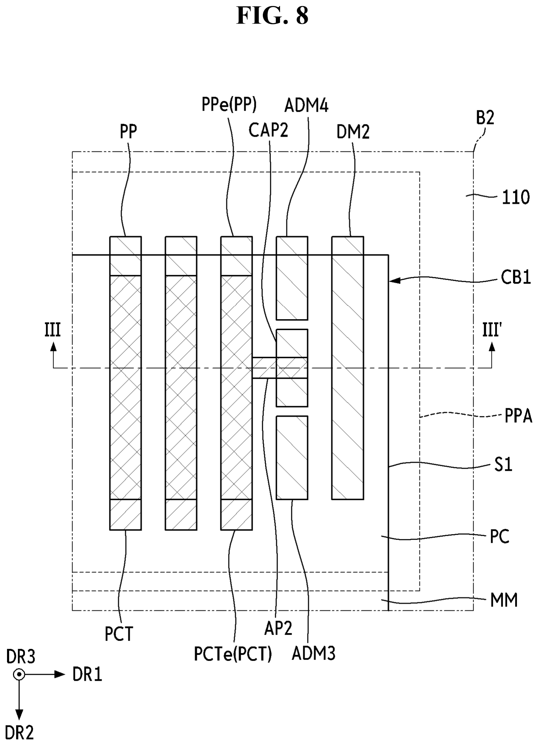

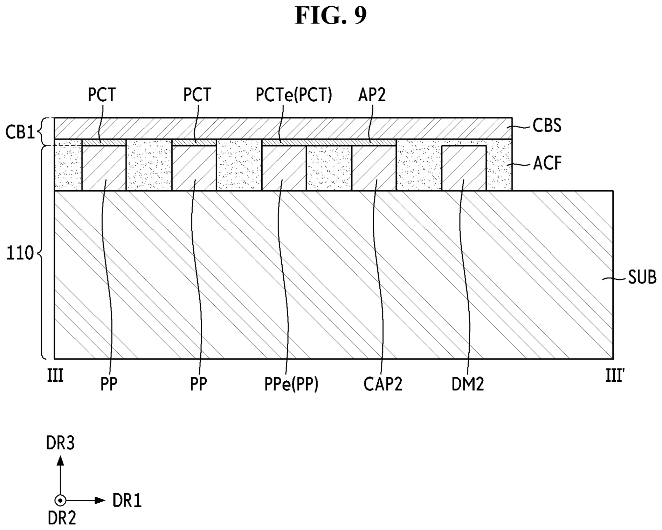

Next, the second alignment pattern AP2, the second counter-alignment pattern CAP2, the second dummy pattern DM2, the third auxiliary dummy pattern ADM3, and the fourth auxiliary dummy pattern ADM4, which are described herein with reference to FIGS. 8 and 9, will be described in detail as follows.

FIG. 8 is an enlarged view illustrating an area B2 of FIG. 2. FIG. 9 is a cross-sectional view taken along line III-III' of FIG. 8.

As illustrated in FIGS. 8 and 9, the display panel 110 may include a substrate SUB, a plurality of panel pads PP, a second counter-alignment pattern CAP2, a second dummy pattern DM2, a third auxiliary dummy pattern ADM3, and a fourth auxiliary dummy pattern ADM4. The plurality of panel pads PP, the second counter-alignment pattern CAP2, the second dummy pattern DM2, the third auxiliary dummy pattern ADM3, and the fourth auxiliary dummy pattern ADM4 may be arranged on the substrate SUB (e.g., an upper surface of the substrate SUB). In this case, the plurality of panel pads PP, the second counter-alignment pattern CAP2, the second dummy pattern DM2, the third auxiliary dummy pattern ADM3 and the fourth auxiliary dummy pattern ADM4 may be formed of the same material (e.g., metal).

The second counter-alignment pattern CAP2 may be arranged adjacent to the panel pad PP in the first direction DR1. For example, the pad area PDA of the display panel 110 may include a plurality of panel pad areas PPA to which a plurality of driving circuit boards CB1 to CB3 are respectively connected, and the second counter-alignment pattern CAP2 may be arranged adjacent to an outermost panel pad PP (hereinafter, referred to as an outermost panel pad PPe) at one side among the plurality of panel pads PP arranged in the panel pad area PPA (hereinafter, referred to as a first panel pad area PPA) to which the first driving circuit board CB1 is connected. In detail, the second counter-alignment pattern CAP2 may be arranged between the outermost panel pad PPe and the second dummy pattern DM2 in the first direction DR1. In this case, the outermost panel pad PPe may be arranged at an outermost portion of one side in the first panel pad area PPA. A size (e.g., area) of the second counter-alignment pattern CAP2 may be smaller than a size (e.g., area) of the panel pad PP. In this case, the area may be a size in the first direction DR1 and the second direction DR2.

The second dummy pattern DM2 may be arranged adjacent to the second counter-alignment pattern CAP2 in the first direction DR1. For example, the second dummy pattern DM2 may be arranged between the second counter-alignment pattern CAP2 and one edge (or the first side S1 of the first driving circuit board CB1) of the first panel pad area PPA in the first direction DR1. The second dummy pattern DM2 may overlap the edge of the first driving circuit board CB1. The second dummy pattern DM2 may have the same size (e.g., area) as the panel pad PP. A thickness of the second dummy pattern DM2 may be the same as a thickness of the panel pad PP. The second dummy pattern DM2 and the panel pad PP may have the same shape. In this case, the area may be a size in the first and second directions DR1 and DR2, and the thickness may be a size in the third direction DR3.

The third auxiliary dummy pattern ADM3 may be arranged between one side of the outermost panel pad PPe and the second dummy pattern DM2 in the first direction DR1. A size of the third auxiliary dummy pattern ADM3 may be smaller than the size of the panel pad PP.

The fourth auxiliary dummy pattern ADM4 may be arranged between the other side of the outermost panel pad PPe and the second dummy pattern DM2. A size of the fourth auxiliary dummy pattern ADM4 may be smaller than the size of the panel pad PP. The fourth auxiliary dummy pattern ADM4 and the third auxiliary dummy pattern ADM3 may have the same size.

The second counter-alignment pattern CAP2 described herein may be arranged between the third auxiliary dummy pattern ADM3 and the fourth auxiliary dummy pattern ADM4 in the second direction DR2. The second counter-alignment pattern CAP2 and the third auxiliary dummy pattern ADM3 may be spaced apart from each other in the second direction DR2 so as not to be connected to each other. The second counter-alignment pattern CAP2 and the fourth auxiliary dummy pattern ADM4 may be spaced apart from each other in the second direction DR2 so as not to be connected to each other.

As illustrated in FIGS. 6 and 7 described herein, the first driving circuit board CB1 may include a base module CBS, a plurality of board connection terminals BCT, a first alignment pattern AP1 and a second alignment pattern AP2. The second alignment pattern AP2 may be arranged in a panel connection module PC of the first driving circuit board CB1.

As illustrated in FIG. 8, the second alignment pattern AP2 of the first driving circuit board CB1 may be connected to a panel connection terminal PCT (hereinafter, referred to as an outermost panel connection terminal PCTe) arranged at an outermost portion of one side among a plurality of panel connection terminals PCT of the first driving circuit board CB1. The second alignment pattern AP2 may extend from the outermost panel connection terminal PCTe toward one edge (or the first side S1 of the first driving circuit board CB1) of the panel connection module PC. For example, the second alignment pattern AP2 may extend from the outermost panel connection terminal PCTe in the first direction DR1. The second alignment pattern AP2 and the panel connection terminal PCT may be formed integrally with each other. The second alignment pattern AP2 may be formed of the same material (e.g., metal) as the material of the panel connection terminal PCT.

The second alignment pattern AP2 may overlap the second counter-alignment pattern CAP2 of the display panel 110. A size of the second alignment pattern AP2 in the second direction DR2 may be smaller than a size of the second counter-alignment pattern CAP2 in the second direction DR2. In an example in which viewed in a plan view as illustrated in FIG. 8, when a distance between the second alignment pattern AP2 and one edge of the second counter-alignment pattern CAP2 is the same as a distance between the second alignment pattern AP2 and the other edge of the second counter-alignment pattern CAP2, it may be determined that the first driving circuit board CB1 and the display panel 110 are normally aligned along the second direction DR2.

A connection member ACF (e.g., an anisotropic conductive film) including conductive balls may be arranged between the display panel 110 and the panel connection module PC of the first driving circuit board CB1. The panel pads PP of the display panel 110 and the panel connection terminals PCT of the first driving circuit board CB1 may be electrically connected to each other by the conductive balls of the connection member ACF.

A thickness of the panel pad PP, a thickness of the second counter-alignment pattern CAP2, a thickness of the second dummy pattern DM2, a thickness of the third auxiliary dummy pattern ADM3, and a thickness of the fourth auxiliary dummy pattern ADM4 may be the same as one another. In this case, the thickness may be a size in the third direction DR3.

A thickness of the panel connection terminal PCT and a thickness of the second alignment pattern AP2 may be the same as each other. In this case, the thickness of the panel pad PP may be greater than the thickness of the panel connection terminal PCT.

According to one embodiment, the second dummy pattern DM2 may be arranged between the edge of the base module CBS of the first driving circuit board CB1 and the substrate SUB of the display panel 110. Accordingly, during the process of attaching the first driving circuit board CB1 and the display panel 110 to each other, a step difference (e.g., a height difference) between a center portion (e.g., a center portion of the first driving circuit board CB1, which overlaps the panel pads PP) of the first driving circuit board CB1 and respective edges (e.g., respective edges of the first driving circuit board CB1, which do not overlap the panel pads PP) of the first driving circuit board CB1 may be minimized. For example, since heat and pressure may be applied to the base module CBS of the first driving circuit board CB1 during the process of attaching the first driving circuit board CB1 to the display panel 110, respective edges of the first driving circuit board CB1, which are not supported by the panel pads PP, may be more deformed than the other portions of the first driving circuit board CB1. However, according to an embodiment, since the second dummy pattern DM2 is arranged on the display panel 110 corresponding to respective edges of the first driving circuit board CB1, respective edges of the first driving circuit board CB1 may be supported by the second dummy pattern DM2 during the process of attaching the first driving circuit board CB1 to the display panel 110. Accordingly, the step difference in the first driving circuit board CB1 may be minimized. As a result, during the process of attaching the first driving circuit board CB1 to the display panel 110, contact resistance (hereinafter, referred to as third contact resistance) between the panel connection terminal PCT and the panel pad PP at the center portion of the first driving circuit board CB1 and contact resistance (hereinafter, referred to as fourth contact resistance) between the panel connection terminal PCT and the panel pad PP in an area adjacent to respective edges of the first driving circuit board CB1 may be maintained almost the same as each other. In other words, deviation between the third contact resistance and the fourth contact resistance may be minimized. Accordingly, electrical connection between the first driving circuit board CB1 and the display panel 110 may be improved.

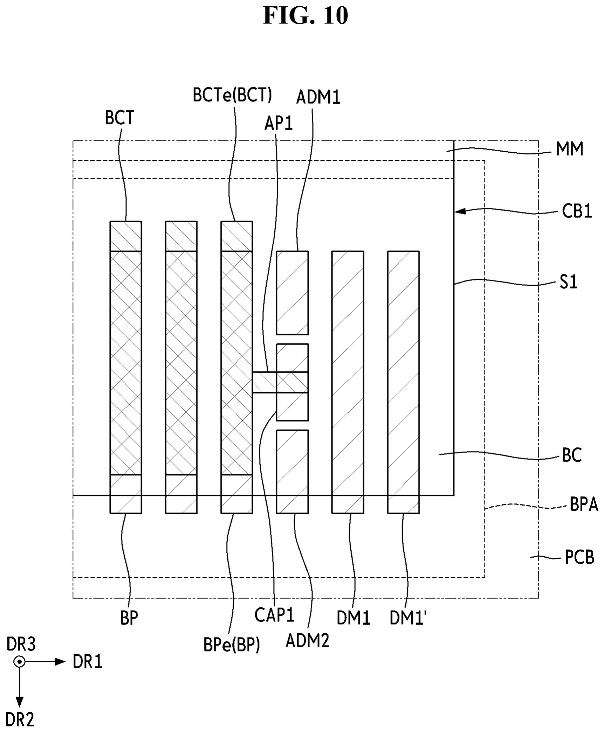

FIG. 10 is an enlarged view illustrating a portion of a display device 100 according to an embodiment. For example, FIG. 10 may be an enlarged view of the display device 100 according to another embodiment of the area B1 of FIG. 2.

The display device 100 of FIG. 10 differs from the display device 100 of FIG. 5 in that it includes a plurality of first dummy patterns DM1 and DM1' at one edge of the board pad area BPA, and this difference will be mainly described as follows.

As illustrated in FIG. 10, the plurality of first dummy patterns DM1 and DM1' may be arranged at one edge of the board pad area BPA (e.g., the first board pad area BPA) of the control circuit board PCB. The plurality of first dummy patterns DM1 and DM1' may have the same size.

The plurality of first dummy patterns may also be arranged at the other edge of the board pad area BPA of the control circuit board PCB.

The second dummy pattern DM2 of the display panel 110 may be provided as a plurality of second dummy patterns. For example, in FIG. 8, another second dummy pattern may be further added between the second dummy pattern DM2 and the first side S1.

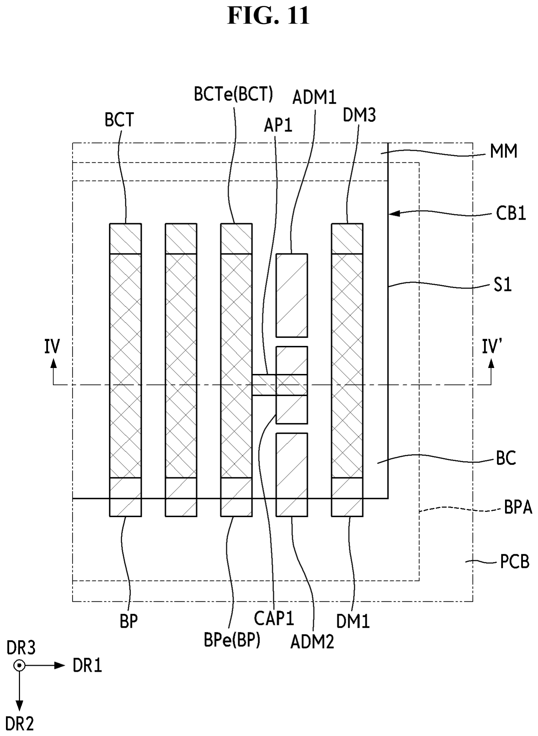

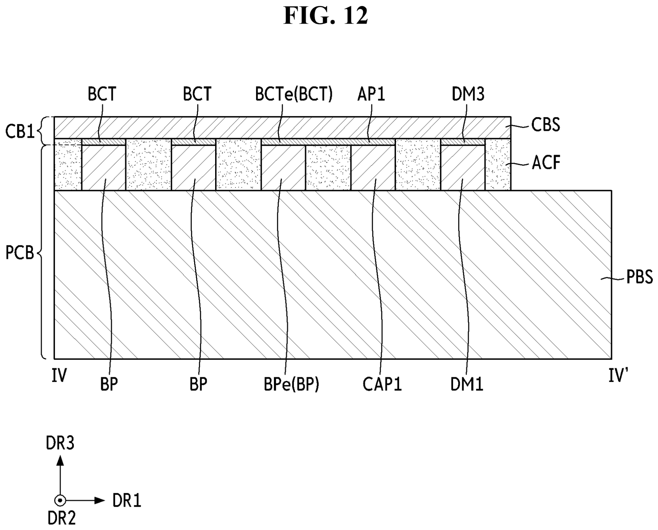

FIG. 11 is an enlarged view illustrating a portion of a display device 100 according to an embodiment. For example, FIG. 11 may be an enlarged view of the display device 100 according to another embodiment of the area B1 of FIG. 2. FIG. 12 is a cross-sectional view taken along line IV-IV' of FIG. 11.

The display device 100 of FIGS. 11 and 12 differs from the display device 100 of FIG. 5 in that a dummy pattern is further added to the first driving circuit board CB1, and this difference will be mainly described as follows.

As illustrated in FIGS. 11 and 12, the first driving circuit board CB1 may further include a third dummy pattern DM3 corresponding to the first dummy pattern DM1 of the control circuit board PCB.

The third dummy pattern DM3 may be arranged in the board connection module BC of the first driving circuit board CB1. For example, the third dummy pattern DM3 may be arranged such that the third dummy pattern DM3 overlaps the first dummy pattern DM1 in the board connection module BC.

The third dummy pattern DM3 may be arranged on the base module CBS (e.g., a lower surface of the base module CBS) of the first driving circuit board CB1. The third dummy pattern DM3 may overlap the first dummy pattern DM1. The third dummy pattern DM3 may be formed of the same material (e.g., metal) as the material of the board connection terminal BCT.

A thickness of the third dummy pattern DM3 may be the same as a thickness of the board connection terminal BCT. In this case, the thickness may be a size in the third direction DR3.

A fourth dummy pattern, which overlaps the second dummy pattern DM2, may be further arranged in the panel connection module PC of the first driving circuit board CB1.

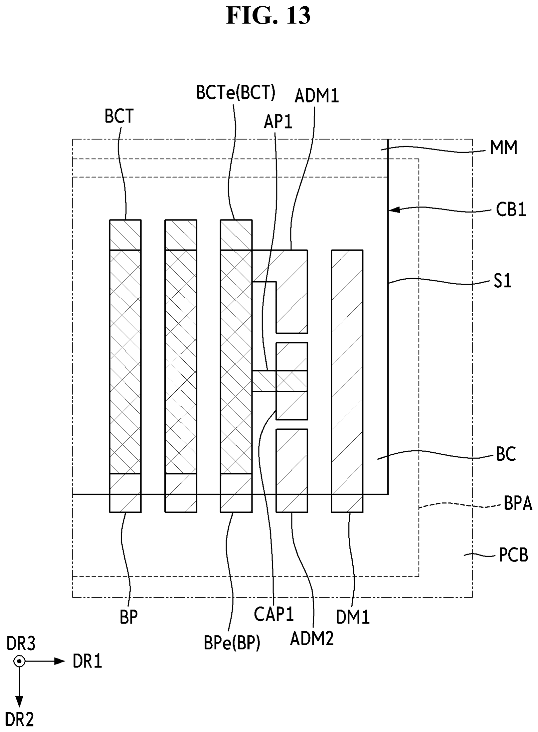

FIG. 13 is an enlarged view illustrating a portion of a display device 100 according to an embodiment. For example, FIG. 13 may be an enlarged view of the display device 100 according to another embodiment of the area B1 of FIG. 2.

The display device 100 of FIG. 13 differs from the display device 100 of FIG. 5 in that the first auxiliary dummy pattern ADM1 and the outermost board pad BPe are connected to each other, and this difference will be mainly described as follows.

According to one embodiment, at least one of the first auxiliary dummy pattern ADM1 or the second auxiliary dummy pattern ADM2 may be connected to the board pad BP. For example, as illustrated in FIG. 13, the first auxiliary dummy pattern ADM1 may be connected to the outermost board pad BPe. For example, the first auxiliary dummy pattern ADM1 may be formed integrally with the outermost board pad BPe.

The second auxiliary dummy pattern ADM2 may be connected to the outermost board pad BPe. For example, the second auxiliary dummy pattern ADM2 may be formed integrally with the outermost board pad BPe. In this case, a voltage from the outermost board pad BPe may be applied to the second auxiliary dummy pattern ADM2, whereby the second auxiliary dummy pattern ADM2 may be prevented from being floated.

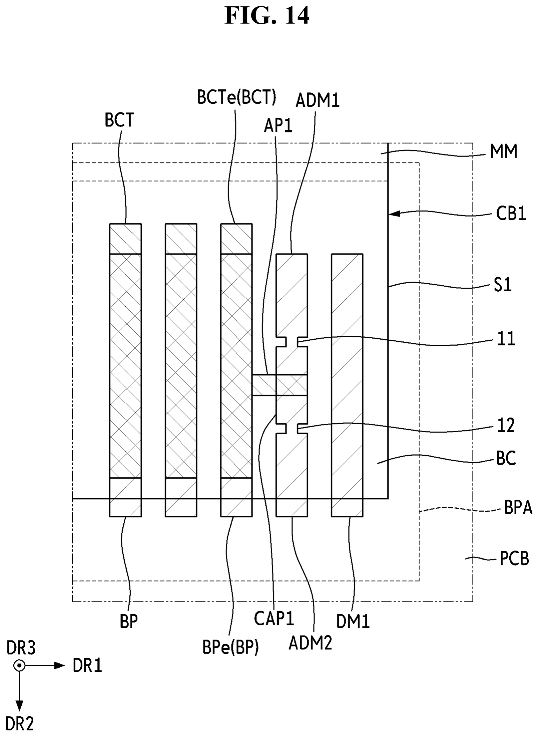

FIG. 14 is an enlarged view illustrating a portion of a display device 100 according to an embodiment. For example, FIG. 14 may be an enlarged view of the display device 100 according to another embodiment of the area B1 of FIG. 2.

The display device 100 of FIG. 14 differs from the display device 100 of FIG. 5 in that the first auxiliary dummy pattern ADM1, the first counter-alignment pattern CAP1, and the second auxiliary dummy pattern ADM2 are connected to one another, and this difference will be mainly described as follows.

As illustrated in FIG. 14, the first auxiliary dummy pattern ADM1, the first counter-alignment pattern CAP1, and the second auxiliary dummy pattern ADM2 may be connected to one another. For example, one side of the first counter-alignment pattern CAP1 may be connected to the first auxiliary dummy pattern ADM1 by a first connection pattern 11, and the other side of the second counter-alignment pattern CAP2 may be connected to the second auxiliary dummy pattern ADM2 by a second connection pattern 12.

An area (e.g., width) of the first connection pattern 11 may be smaller than an area (e.g., width) of the first auxiliary dummy pattern ADM1 and an area (e.g., width) of the first counter-alignment pattern CAP1. In this case, the width may be a size in the first direction DR1.

An area (e.g., width) of the second connection pattern 12 may be smaller than an area (e.g., width) of the second auxiliary dummy pattern ADM2 and an area (e.g., width) of the first counter-alignment pattern CAP1. In this case, the width may be a size in the first direction DR1.

As illustrated in FIG. 14, since each width of the first connection pattern 11 and the second connection pattern 12 is smaller than each width of the first auxiliary dummy pattern ADM1, the second counter-alignment pattern CAP2, and the second auxiliary dummy pattern ADM2, the position of the first alignment pattern AP1 on the first counter-alignment pattern CAP1 may be easily detected. Furthermore, since the first auxiliary dummy pattern ADM1, the first counter-alignment pattern CAP1, and the second auxiliary dummy pattern ADM2 are connected to one another by the first connection pattern 11 and the second connection pattern 12, the step difference in the first driving circuit board CB1 may be further minimized during the attachment process between the first driving circuit board CB1 and the control circuit board PCB.

In some aspects, since the first auxiliary dummy pattern ADM1, the first counter-alignment pattern CAP1, and the second auxiliary dummy pattern ADM2 are connected to one another by the first connection pattern 11 and the second connection pattern 12, even though a voltage is applied to any one of the first auxiliary dummy pattern ADM1, the first counter-alignment pattern CAP1 and the second auxiliary dummy pattern ADM2, the voltage may be provided to the first auxiliary dummy pattern ADM1, the first counter-alignment pattern CAP1 and the second auxiliary dummy pattern ADM2. In this case, the first auxiliary dummy pattern ADM1, the first counter-alignment pattern CAP1 and the second auxiliary dummy pattern ADM2 may be prevented from being floated. The first auxiliary dummy pattern ADM1 of FIG. 14 may be connected to the outermost board pad BPe as illustrated in FIG. 13.

In FIG. 8, the third auxiliary dummy pattern ADM3, the second counter-alignment pattern CAP2 and the fourth auxiliary dummy pattern ADM4 may be connected to one another. For example, one side of the second counter-alignment pattern CAP2 and the third auxiliary dummy pattern ADM3 may be connected to each other by the first connection pattern as described herein, and the other side of the second counter-alignment pattern CAP2 and the second auxiliary dummy pattern ADM2 may be connected to each other by the second connection pattern as described herein.

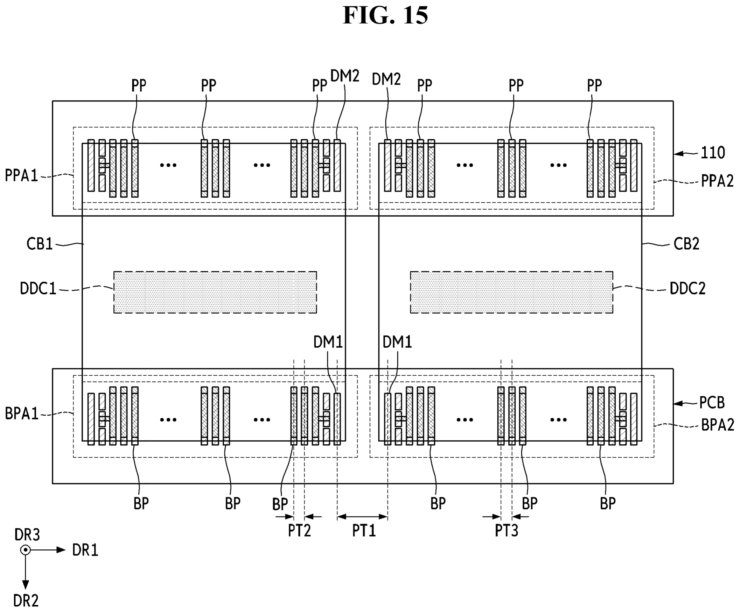

FIG. 15 is a plan view illustrating a display device 100 according to an embodiment.

As illustrated in FIG. 15, the first driving circuit board CB1 may be connected to the first panel pad area PPA1 of the display panel 110 and the first board pad area BPA1 of the control circuit board PCB, and the second driving circuit board CB2 may be connected to the second panel pad area PPA2 of the display panel 110 and the second board pad area BPA2 of the control circuit board PCB.

For example, the panel connection terminals PCT of the first driving circuit board CB1 may be connected to the panel pads PP provided in the first panel pad area PPA1 of the display panel 110, the board connection terminals BCT of the first driving circuit board CB1 may be connected to the board pads BP provided in the first board pad area BPA1 of the control circuit board PCB, and the panel connection terminals PCT of the second driving circuit board CB2 may be connected to the panel pads PP provided in the second panel pad area PPA2 of the display panel 110, and the board connection terminals BCT of the second driving circuit board CB2 may be connected to the board pads BP provided in the second board pad area BPA2 of the control circuit board PCB.

As illustrated in FIG. 15, a pitch between the first dummy patterns DM1 that overlap the driving circuit boards CB1 and CB2 adjacent thereto may be different from a pitch between the board pads BP that overlap any one of the driving circuit boards. In an example in which a pitch between the first dummy pattern DM1 overlapping the first driving circuit board CB1 and the first dummy pattern DM1 overlapping the second driving circuit board CB2 is defined as a first pitch PT1, and a pitch between the board pads BP overlapping the first driving circuit board CB1 is defined as a second pitch PT2, the first pitch PT1 may be greater than the second pitch PT2. For example, the first pitch PT1 may be more than twice the second pitch PT2. The pitch may be defined as a distance between centers of the board pads BP adjacent to each other, or a distance between centers of the first dummy patterns DM1 adjacent to each other.

When a pitch between the board pads BP overlapping the second driving circuit board CB2 is defined as a third pitch PT3, the third pitch PT3 may be the same as the second pitch PT2 and may be smaller than the first pitch PT1.

Since the pitch PT1 of the patterns (e.g., the first dummy patterns DM1) arranged adjacent to each other at each edge of the adjacent board pad areas BPA1 and BPA2 is different from the pitch PT2 of the patterns (e.g., the board pads BP) arranged adjacent to each other in any one of the board pad areas BPA1 and BPA2, a boundary between the plurality of board pad areas BPA1 and BPA2 may be easily detected in the control circuit board PCB. Therefore, an alignment operation between the plurality of driving circuit boards CB1 to CB3 and the control circuit board PCB may be easily performed.

At least one of the first alignment pattern AP1, the second alignment pattern AP2, the first counter-alignment pattern CAP1, the second counter-alignment pattern CAP2, the first dummy pattern DM1, the second dummy pattern DM2, the third dummy pattern DM3, the fourth dummy pattern, the first auxiliary dummy pattern ADM1, the second auxiliary dummy pattern ADM2, the third auxiliary dummy pattern ADM3, or the fourth auxiliary dummy pattern ADM4 may be maintained in a floating state.

Alternatively, at least one of the first alignment pattern AP1, the second alignment pattern AP2, the first counter-alignment pattern CAP1, the second counter-alignment pattern CAP2, the first dummy pattern DM1, the second dummy pattern DM2, the third dummy pattern DM3, the fourth dummy pattern, the first auxiliary dummy pattern ADM1, the second auxiliary dummy pattern ADM2, the third auxiliary dummy pattern ADM3, or the fourth auxiliary dummy pattern ADM4 may receive a voltage (e.g., a constant voltage). This voltage may be provided, for example, from the power supply module described herein.

The display device 100 according to the embodiment may be applied to various electronic devices. The electronic device according to an embodiment includes the above-described display device 100, and may further include modules or devices, which have other additional functions, in addition to the display device 100.

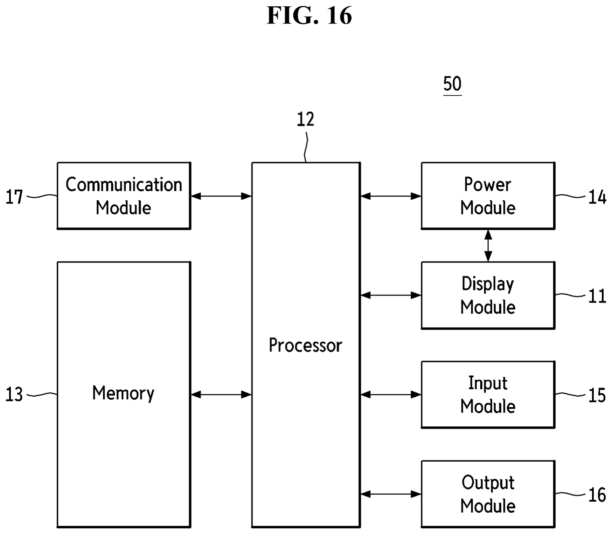

FIG. 16 is a block diagram illustrating an electronic device according to an embodiment. Referring to FIG. 16, an electronic device 50 according to an embodiment may include a display module 11, a processor 12, a memory 13, and a power module 14. The electronic device 50 may further include an input module 14, a non-image output module 15, and/or a communication module 16.

The electronic device 50 may output various types of information as an image through the display module 11. In an example in which the processor 12 executes an application stored in the memory 13, the electronic device 50 may provide image information provided by the application to a user through the display module 11. The power module 14 may include a power supply module such as a power adapter or a battery device, and a power conversion module that converts a power source supplied by the power supply module to generate a power source for an operation of the electronic device 50. The input module 14 may provide input information to the processor 12 and/or the display module 11. The non-image output module 15 may serve to receive information other than the image received from the processor 12, for example, information such as sound, haptic, and light emission, and provide the received information to a user. The communication module 16 is a module responsible for transmitting and receiving information between the electronic device 50 and an external device, and may include a receiving module and a transmitting module.

At least one of the respective components of the electronic device 50 described herein may be included in the display device according to the above-described embodiments. In some aspects, some of the individual modules functionally included in one module may be included in the display device, and others thereof may be provided separately from the display device. For example, the display device includes the display module 11, and the processor 12, the memory 13 and the power module 14 may be provided as other devices in the electronic device 50 not the display device.

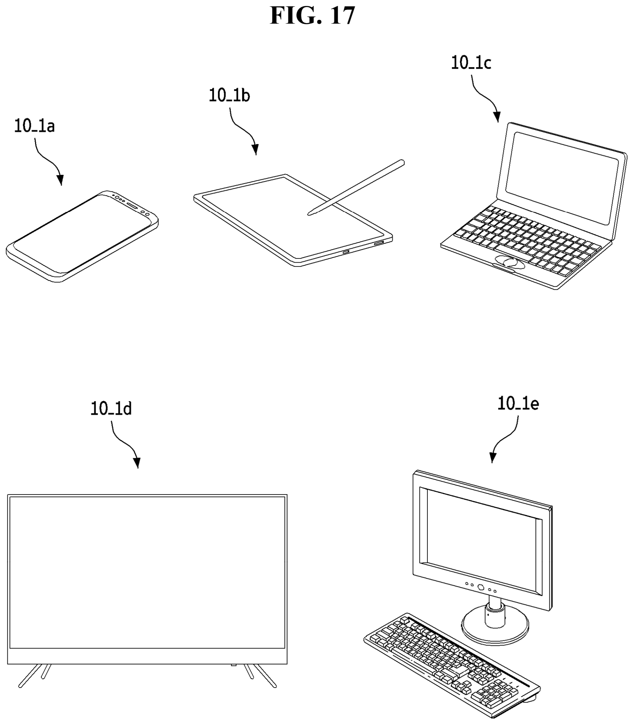

FIGS. 17, 18 and 19 illustrates schematic diagrams of electronic devices according to various embodiments. FIGS. 17 to 19 illustrate examples of various electronic devices to which the display device 100 according to embodiments is applied.

FIG. 17 illustrates a smartphone 10_1a, a tablet PC 10_1b, a laptop 10_1c, a TV 10_1d, and a desk monitor 10_1e as examples of the electronic devices.

The smartphone 10_1a may include an input module such as a touch sensor and a communication module in addition to the display module 11. The smartphone 10_1a may process information received through the communication module or other input module to display the information through the display module of the display device.

Similarly to the smartphone 10_1a, the tablet PC 10_1b, the laptop 10_1c, the TV 10_1d, and the desk monitor 10_1e include a display module and an input module, and in some cases, may further include a communication module.

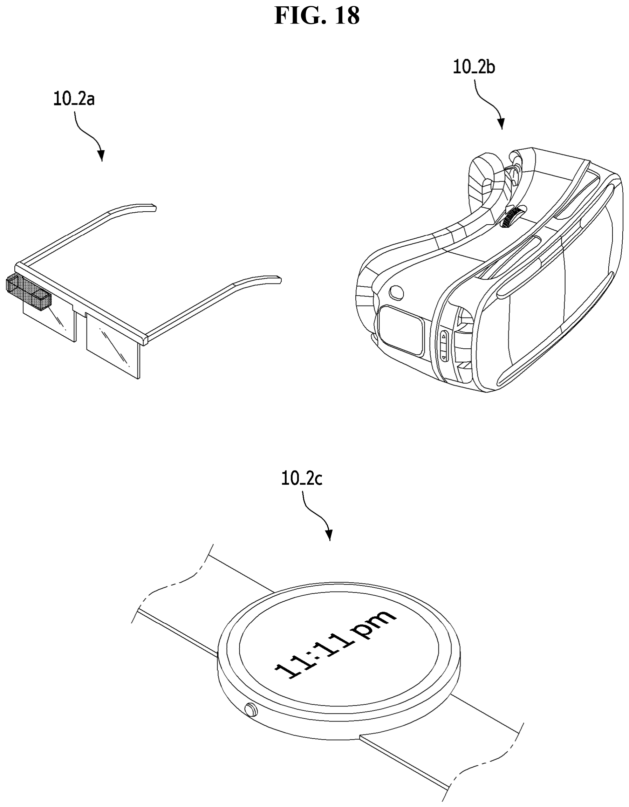

FIG. 18 illustrates a case in which an electronic device including a display module is applied to a wearable electronic device. The wearable electronic device may be a smart glasses 10_2a, a head mounted display 10_2b, a smart watch 10_2c, or the like.

The smart glasses 10_2a and the head mounted display 10_2b may include a display module that emits a display image and a reflector that reflects and provides the emitted display screen to a user's eyes, thereby providing a screen of virtual reality or augmented reality to the user.

The smart watch 10_2c includes a biometric sensor as an input device, and may provide biometric information recognized through the biometric sensor to the user through the display module.

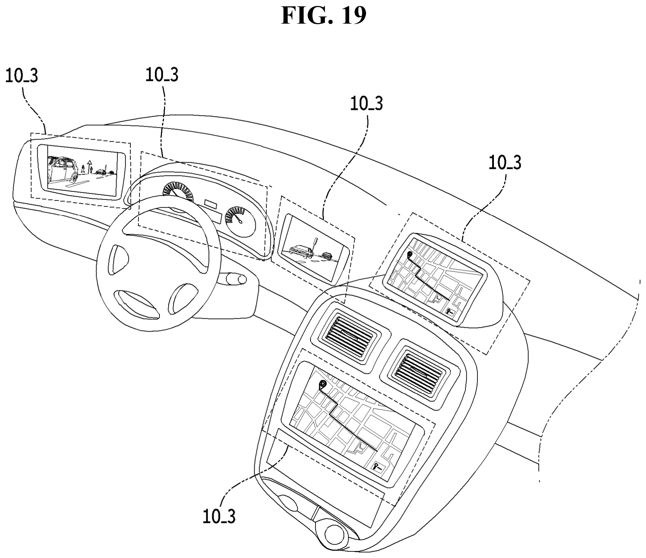

FIG. 19 illustrates a case in which an electronic device including a display module is applied to a vehicle. For example, the electronic device 10_3 may be applied to a vehicle dashboard, a center fascia, or the like, or may be applied to a center information display (CID) arranged on the vehicle dashboard, and a room mirror display replacing a side mirror.

In concluding the detailed description, those skilled in the art will appreciate that many variations and modifications can be made to the example embodiments without substantially departing from the principles of the present invention. Therefore, the disclosed example embodiments of the present disclosure are used in a generic and descriptive sense and not for purposes of limitation.

The display device defined in claim 1 provides the significant technical advantage of an improved and more reliable electrical connection between the flexible first circuit board and the rigid second circuit board. The dummy pattern on the second circuit board acts as a physical support structure directly under the edges of the first circuit board during the heat-and-pressure bonding process. This support prevents the board's edges from deforming, thereby minimizing the step-difference between the center and the edges of the connection area. As a result, a uniform contact pressure is maintained across all connection terminals, ensuring a consistent, low-resistance electrical connection. This improves manufacturing yield and enhances the overall reliability and performance of the final display device.

In addition to providing the mechanical support benefits a further advantage is introduced by ensuring precise alignment during the manufacturing process. The introduction of a first alignment pattern on the first circuit board and a corresponding first counter-alignment pattern on the second circuit board creates a fiducial system. By overlapping these patterns, manufacturers can precisely verify and control the positioning of the two boards relative to each other before and during bonding. This guarantees that the board connection terminals are accurately placed onto their respective board pads (BP), which is critical for preventing electrical opens or shorts, especially in high-density connection areas. The technical effect is a more robust and forgiving manufacturing process with a higher yield. This combination of mechanical support from the dummy pattern and precision from the alignment patterns results in a highly reliable, high-density connection suitable for modern display technologies.

By precisely defining the location of the first dummy pattern, an additional level of optimization for manufacturability is provided. Placing the dummy pattern specifically between the counter-alignment pattern and the physical edge of the circuit board achieves two distinct technical effects. Firstly, it ensures the dummy pattern provides maximum mechanical support at the most vulnerable overhanging position, further guaranteeing a uniform connection pressure. Secondly, this specific arrangement spatially separates the support function of the dummy pattern from the positioning function of the alignment patterns. This prevents the dummy pattern from interfering with the automated optical systems used to verify alignment, leading to a more robust and error-free manufacturing process.

By making the thickness of the first dummy pattern the same as the board pad, a perfectly level support surface is created. This eliminates any step-difference, ensuring uniform bonding pressure and resulting in highly consistent and reliable electrical connections across the entire interface.

By making the area of the first dummy pattern the same as a functional board pad, it is ensured that mechanical and thermal properties are consistent across the entire connection interface. This mimicry results in a uniform distribution of pressure and heat during the bonding process, preventing localized stress and ensuring a more reliable and homogeneous connection.

By matching the shape of the first dummy pattern to that of a functional board pad, the manufacturing process is further simplified. This allows both dummy and functional patterns to be created using the same design and fabrication steps, ensuring consistent process results like uniform etching. The primary technical effect is enhanced process control, which contributes to a more reliable and homogeneous connection interface.

Keeping the first dummy pattern in a floating state ensures it remains electrically inert. This prevents it from acting as an antenna for electromagnetic interference or causing crosstalk with adjacent signal lines, thereby protecting the signal integrity of the device while it performs its primary mechanical support function.

Applying a stable voltage, such as ground, to the first dummy pattern transforms it into a dual-purpose component. This provides a safe path for electrostatic discharge (ESD) to dissipate, protecting sensitive circuits, and allows the pattern to function as an effective shield against electromagnetic interference, enhancing the device's overall electrical robustness.

Making the counter-alignment pattern smaller than a standard board pad creates a visually distinct feature. This enhances the accuracy and speed of automated optical alignment systems, as the smaller pattern is easily differentiated from the array of larger board pads, reducing the risk of misalignment during manufacturing.

Maintaining the first counter-alignment pattern in a floating state ensures it does not electrically interfere with nearby circuits. This prevents potential signal integrity issues like crosstalk, guaranteeing that its function remains purely for optical alignment without any adverse electrical side effects.

Connecting the first counter-alignment pattern to a stable voltage provides enhanced electrostatic discharge (ESD) protection directly at the alignment site. This dual-purpose design protects sensitive circuitry from static damage during handling and manufacturing while still serving its primary function as a precise alignment mark.

The addition of a first auxiliary dummy pattern provides more complete and continuous mechanical support in the critical area around the alignment pattern. This further minimizes any localized height differences, ensuring a highly uniform bonding pressure and maximizing the reliability of the electrical connection.

This specific placement creates a finely-tuned support structure, filling the precise gap between the outermost functional pad and the main dummy pattern. This optimizes the distribution of mechanical support, preventing any unsupported regions and ensuring a seamless, uniform bonding surface for the highest connection quality.

Making the auxiliary dummy pattern smaller than a board pad ensures it does not create excessive metal density while still providing targeted support. This balances the need for mechanical stability with an optimized circuit layout that manages thermal properties and reduces the risk of shorts.

Matching the area of the auxiliary dummy pattern to the counter-alignment pattern creates a symmetrical and balanced layout in the alignment zone. This promotes uniform thermal and mechanical behavior during bonding, enhancing process stability and predictability.

Using the same shape for the auxiliary dummy pattern and the counter-alignment pattern simplifies the design and fabrication process. This ensures consistent manufacturing results, such as uniform etching and plating, which is critical for process control with such fine features.

The addition of a second auxiliary dummy pattern creates a perfectly symmetrical support structure that brackets the central alignment pattern. This symmetrical design balances the mechanical forces and thermal distribution during bonding, preventing any tilting or uneven pressure and leading to a maximally stable and reliable connection.

This specific arrangement completes the symmetrical support structure around the alignment pattern. By precisely placing the second auxiliary dummy pattern, it ensures that the entire region between the functional pads and the main dummy pattern is fully supported, eliminating gaps and creating an ideal, level surface for bonding.

Incorporating the specified display device into a complete electronic product, such as a smartphone or monitor, confers the advantage of enhanced overall product reliability. The improved electrical connection within the display component leads to fewer failures, better performance, and a more robust final product for the end-user.

## Claims

1. A display device (100) comprising:
a display panel (110);
a first circuit board (CB1) connected to the display panel (110); and
a second circuit board (PCB) connected to the first circuit board (CB1),
wherein the first circuit board (CB1) comprises a board connection terminal (BCT), and he second circuit board (PCB) comprises:
a board pad (BP) connected to the board connection terminal (BCT); and
a dummy pattern (DM1) arranged adjacent to the board pad (BP) and which overlaps an edge of the first circuit board (CB1).

2. The display device (100) of claim 1, wherein: the first circuit board (CB1) further comprises a first alignment pattern (AP1) extended from the board connection terminal (BCT), the second circuit board (PCB) further comprises a first counter-alignment pattern (CAP1) that overlaps the first alignment pattern (AP1), and the dummy pattern is a first dummy pattern (DM1) arranged adjacent to the first counter-alignment pattern (CAP1).

3. The display device (100) of claim 2, wherein the first dummy pattern (DM1) is arranged between the first counter-alignment pattern (CAP1) and an edge of the first circuit board (CB1).

4. The display device (100) of claim 1 or 2, wherein a thickness of the first dummy pattern (DM1) is the same as a thickness of the board pad (BP).

5. The display device (100) of claim 1 or 2, wherein an area of the first dummy pattern (DM1) is the same as an area of the board pad (BP).

6. The display device (100) of claim 1 or 2, wherein a shape of the first dummy pattern (DM1) and a shape of the board pad (BP) are the same as each other.

7. The display device (100) of claim 1 or 2, wherein the first dummy pattern (DM1) is maintained in a floating state.

8. The display device (100) of claim 1 or 2, wherein the first dummy pattern (DM1) receives a voltage.

9. The display device (100) of claim 2, wherein an area of the first counter-alignment pattern (CAP1) is smaller than an area of the board pad (BP).

10. The display device (100) of claim 2, wherein the first counter-alignment pattern (CAP1) is maintained in a floating state.

11. The display device (100) of claim 2, wherein the first counter-alignment pattern (CAP1) receives a voltage.

12. The display device (100) of claim 2, wherein the second circuit board (PCB) further comprises a first auxiliary dummy pattern (ADM1) arranged at one side of the first counter-alignment pattern (CAP1) and spaced apart from the first counter-alignment pattern (CAP1).

13. The display device (100) of claim 12, wherein the first auxiliary dummy pattern (ADM1) is arranged between one side of the board pad (BP) and one side of the first dummy pattern (BP).

14. The display device (100) of claim 12, wherein an area of the first auxiliary dummy pattern (ADM1) is smaller than an area of the board pad (BP).

15. The display device (100) of claim 12, wherein an area of the first auxiliary dummy pattern (ADM1) is the same as an area of the first counter-alignment pattern (CAP1).

16. The display device (100) of claim 12, wherein a shape of the first auxiliary dummy pattern (ADM1) and a shape of the first counter-alignment pattern (CAP1) are the same as each other.

17. The display device (100) of claim 12, wherein the second circuit board (PCB) further comprises a second auxiliary dummy pattern (ADM2) arranged at another side of the first counter-alignment pattern (CAP1) and spaced apart from the first counter-alignment pattern (CAP1).

18. The display device (100) of claim 17, wherein the second auxiliary dummy pattern (ADM2) is arranged between another side of the board pad (BP) and another side of the first dummy pattern (DM1).

19. An electronic device (50) comprising a display device (100) providing a display screen (DA), wherein the display device (100) is according to any one of claims 1 to 18.
